Europäisches Patentamt

European Patent Office

Office européen des brevets

(19)

(11) Publication number : **0 517 627 A1**

(12) **EUROPEAN PATENT APPLICATION**

(21) Application number : **92420184.1**

(22) Date of filing : **03.06.92**

(51) Int. Cl.$^5$ : **H01L 21/308, H01L 21/314**

(30) Priority : **07.06.91 US 711766**

(43) Date of publication of application :
**09.12.92 Bulletin 92/50**

(84) Designated Contracting States :
**DE FR GB**

(71) Applicant : **EASTMAN KODAK COMPANY**
**343 State Street**
**Rochester, New York 14650-2201 (US)**

(72) Inventor : **Franke, Hans George, c/o EASTMAN KODAK COMPANY**
**Patent Legal Staff, 343 State Street**
**Rochester, New York 14650-2201 (US)**
Inventor : **Prince, Eric Thompson, c/o EASTMAN KODAK COMPANY**
**Patent Legal Staff, 343 State Street**
**Rochester, New York 14650-2201 (US)**
Inventor : **Roselle, Paul Lucas, c/o EASTMAN KODAK COMPANY**
**Patent Legal Staff, 343 State Street**
**Rochester, New York 14650-2201 (US)**

(74) Representative : **Buff, Michel et al**
**Kodak-Pathé Département des Brevets et Licences CRT Centre de Recherches et de Technologie Zone Industrielle**
**F-71102 Chalon sur Saône Cédex (FR)**

(54) **Deposited carbon mask for dry etch processing of Si.**

(57) A mask is described which enables the fabrication of features in Si such as trenches for electrical isolation by dry etch processing in chlorine containing ambients. The mask consists of an amorphous form of carbon which may contain incorporated hydrogen. The mask can be applied, patterned and removed through dry processing techniques.

FIG. Id

EP 0 517 627 A1

## Field of the Invention

This invention relates to the protection of desired regions of Si by a durable mask during dry etch processing. More specifically, this invention relates to the use of a durable carbon etch mask to protect desired regions of Si during the fabrication of features such as trenches by dry etch processing in chlorine containing ambients.

## BACKGROUND OF THE INVENTION

Fabrication of micro-electronic devices in Si requires the use of etch processes to produce features for both microoptical and microelectronic components such as trenches for electrical isolation. To prepare components of this type having small, often sub-micron size dimensions, etch processes which provide a high degree of anisotropy are required. Wet etch techniques are, in general, unsuitable. Etch rates in wet processes are either isotropic or dependent on crystallographic orientation. Dry etch techniques, on the other hand, can avoid the dependence in rate (under optimum conditions) to crystallographic orientation and can provide the anisotropy required.

The majority of dry techniques used to provide an anisotropic etch in Si are ion-based processes which utilize chemistry to provide some form of reactive assistance. The most common techniques of this type include: Reactive Ion Etching (RIE), Reactive Ion Beam Etching (RIBE), and Ion Beam Assisted Etching (IBAE) [also known as Chemically-Assisted Ion Beam Etching (CAIBE)]. The chemistry utilized by these techniques for reactive assistance enhances etch rates, forms volatile etch products, and minimizes damage to the Si surface by energetic ions, neutrals, and/or radicals. In the dry etch processing of Si, ambients containing chlorine (atoms, molecules, neutrals, radicals) have been found most useful for providing suitable reactive assistance.

Some form of mask is required to protect desired regions of a substrate when using dry techniques to etch Si. Durable masks are often of particular value. The term "durable" as used herein defines the resistance of the mask to erosion during an etch process. An ideal mask is durable to the extent that it will not erode or change form during an etch process. For a mask to exhibit significant durability in the dry etch processing of Si, the ratio of the etch rate of the Si to that of the mask, i.e., the selectivity of the etch, must be high. Masks of materials of low durability are unsuitable for several reasons. First, the edge quality of etch features decreases as mask thickness increases. Second, mask features of dimensions smaller than the thickness of the mask are unstable and can break away or shift position during processing. Finally, mask erosion especially of edges can redeposit mask material into unwanted regions and degrade overall etch quality and uniformity.

In the dry etching of Si using chlorine for chemical assistance, few materials are known which when applied as thin layers (ca. 0.1 micron) offer the durability to survive an etch of from a few to many microns. Photoresist, the most commonly used etch mask, does not have suitable durability to allow for the etching of Si trenches 10 $\mu$m deep. What are needed are masks of high durability which are convenient to apply, pattern, and remove.

## SUMMARY OF THE INVENTION

An object of this invention is to provide a durable mask for the dry etch processing of Si in chlorine containing ambients. Quite unexpectedly, we have discovered that a mask formed of amorphous carbon is resistant to attack by chlorine during dry etch processing in chlorine containing ambients. The amorphous carbon can be applied and removed by dry processing techniques.

## BRIEF DESCRIPTION OF THE DRAWINGS

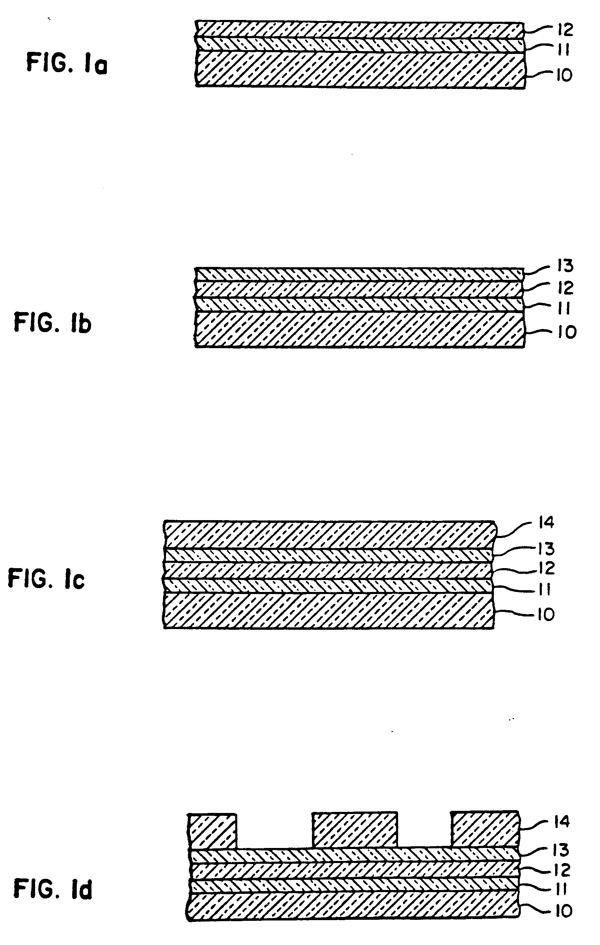

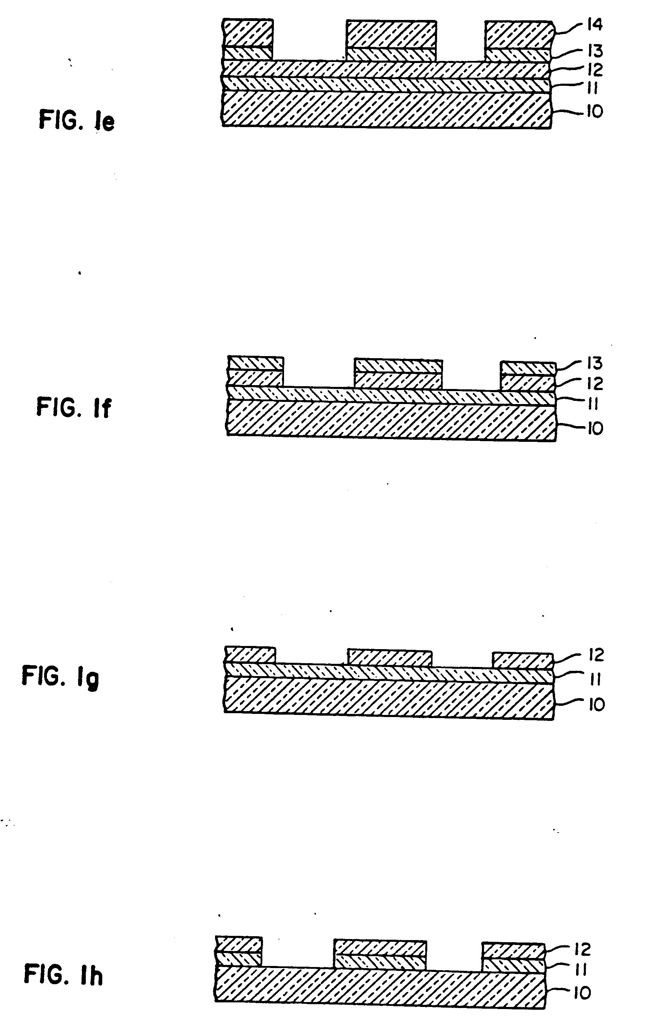

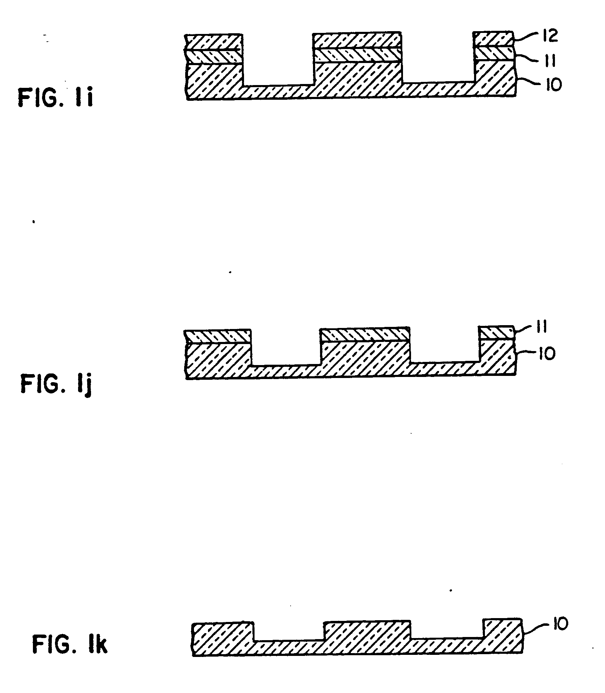

Figures 1 (a-k) are sectional views illustrating various steps in the preferred method of forming and removing the durable mask resistant to attack by chlorine.

## MODES OF CARRYING OUT THE INVENTION

A mask of amorphous carbon can be prepared by a plasma-assisted CVD technique, i.e., by the decomposition of methane in an rf plasma. Other hydrocarbons may be substituted for methane and a wide range of process conditions may be used. Alternative techniques for depositing this material may be used as well. These include variations of the plasma-assisted CVD technique, glow discharge (rf and DC) sputter deposition, single and dual ion beam sputter deposition, reactive ion beam deposition, evaporation, and ion plating. Depending on the deposition technique selected, the chemical and physical properties of the carbon mask may vary; the chemical properties from amorphous carbon (a-C) to hydrogenated amorphous carbon (a-C:H), the physical properties from diamond-like to graphite-like.

Amorphous carbons which serve as highly durable masks are determined easily through routine examination using, for example, scanning electron microscopy (SEM), and experiments such as those described in subsequent Examples I and II. To be considered durable, the ratio of the etch rate of Si to that of the mask should exceed 3:1 and more typically, 6:1. The ambient under which this durability is established may include chlorine containing gases or gas mixtures other than those given by the examples, e.g. $BCl_3$, $BCl_3/Ar$, etc., as long as the ambient is a suitable ambient for the dry etching of Si.

As shown in Figure 1a, a layer of amorphous carbon 12 is deposited on a substrate 10 of Si which may or may not contain an overcoating 11 of a material such as $SiO_2$, $Si_3N_4$ or amorphous silicon. An amorphous material is preferred for layer 11 to prevent transfer of grain boundary features. This overlayer, when present, provides an adhesion layer for the amorphous carbon and protects the surface of the Si from damage by ion bombardement during the deposition of the amorphous carbon. As shown in Figure 1b, a thin layer 13 of a material such as $SiO_2$, $Si_3N_4$, or amorphous silicon, is applied over the amorphous carbon layer. Again, an amorphous material is preferred for this layer to prevent transfer of grain boundary features. A layer 14 of a lithographically patternable material, e.g., photoresist or an electron beam sensitive resist, is then applied to the surface layer 13 as shown in Figure 1c. Layer 14 is then exposed and developed according to accepted practices to provide a pattern as shown in Figure 1d. Next a Reactive Ion Etch (RIE) step is used with an appropriate gas chemistry to selectively etch layer 13 through the exposed regions of the pattern in layer 14 as shown in Figure 1e. Alternative dry etch techniques may be substituted for any of the RIE steps specified in this description whenever convenient. If layer 13 is composed of $SiO_2$ or amorphous silicon a Freon/oxygen mixture such as $CF_4/O_2$ (96 vol% $CF_4$, 4 vol% $0_2$) can be used to selectively remove this layer by RIE. Another dry etch by RIE is then performed using oxygen ($O_2$) to selectively transfer the mask pattern in layer 13 through the amorphous carbon layer 14 to provide openings. This etch may also be used to remove the lithographically patternable layer 14 (Figure 1f). The sample is then dry etched by RIE using a suitable selective gas to remove the remaining layer 13 pattern (Figure 1g). By proper choice of materials this RIE step can also be useful for patterning layer 11 when present (Figure 1b). At this point, the processing of the amorphous carbon mask with patterned openings which expose the Si substrate is complete and the wafer is ready for dry etching in a chlorine containing ambient. Following transfer of the pattern into Si (Figure 1i), the amorphous carbon layer 12 is removed by RIE in $O_2$ (Figure 1j). Finally, the adhesion/protection layer 11 when present is removed by RIE under the same conditions used during pattern transfer (Figure 1k).

## EXAMPLES

Two examples are presented here to illustrate the durability of amorphous carbon masks in the dry etch processing of Si in chlorine containing ambients using RIE. For convenience reasons only, the means used to pattern the amorphous carbon in these examples deviate from the means described in the preferred embodiment. Also, the anisotropy of the etch was of no concern in the first example. RIE conditions are presented which do not optimize this aspect.

I. In the first example an amorphous carbon layer of thickness $1.38 \mu$ was deposited onto an evaporated $SiO_2$ adhesion/protection layer of thickness $0.34 \mu$ on a Si substrate. The amorphous carbon was deposited by the plasma-assisted CVD technique onto an rf powered electrode at a self-bias voltage of 1600V and a methane pressure of $16 \mu$ Torr. Photoresist was applied and patterned for application of an Imidazole-based photoresist lift-off process. After preparation of the appropriate photoresist profile for the lift-off process aluminum was deposited to a thickness of 0.1m over the profile. The resultant lift-off pattern of aluminum on the amorphous carbon surface was then transferred through the amorphous carbon layer by RIE at 300 W in $O_2$ at a pressure of $40 \mu$ Torr. RIE was again used to transfer the pattern through the $SiO_2$ adhesion/protection layer at 300 W in $CF_4/O_2$ (96 vol% $CF_4$, 4 vol% $O_2$) at a pressure of $100 \mu$ Torr. A wet etchant was next used to strip the aluminum from the sample. Features to depths of $3.0 \mu$ were dry etched through openings in the amorphous carbon and $SiO_2$ mask layers into the Si substrate by RIE at 400 W using flows of 20 sccm $BlCl_3$, 30 sccm $Cl_2$, 30 sccm $N_2$ at a pressure of $125 \mu$ Torr. Under these conditions the selectivity, i.e., the ratio of etch rate of the Si to that of the amorphous carbon, was found to be 4:1. RIE at 300 W in $0_2$ at $40 \mu$ Torr was used to remove the remaining amorphous carbon and RIE at 300 W in $CF_4/O_2$ (96 vol% $CF_4$, 4 vol% $O_2$) at $100 \mu$ Torr as used to remove the $SiO_2$ adhesion/protection layer.

The second example was the same as the first with only the RIE etch of Si changed to improve the selectivity to the carbon mask. In this case the silicon was etched to a depth of 3 μm by RIE at 250 W using flows of 20 sccm $BCl_3$ and 30 sccm $Cl_2$ at a pressure of $125 \mu$ Torr. Under these conditions the selectivity, i.e. the ratio of etch rate of Si to that of the amorphous carbon was found to be 6:1.

## INDUSTRIAL APPLICABILITY AND ADVANTAGES

A feature of this invention is that no wet etch steps are required following lithographic patterning.

Another feature is that the amorphous carbon mask facilitates the fabrication of features such as trenches by dry etch processing in chlorine containing ambients.

## Claims

1. A method of forming a durable mask for use in the dry etch processing of Si, characterized by the steps of:

(a) providing a layer of amorphous carbon over the Si, said layer being resistant to attack by chlorine on Si;

(b) forming openings in the amorphous carbon layer to expose the Si layer by dry processing to form an amorphous mask;

(c) dry etch processing of Si in chlorine containing ambients through the opening in the mask; and

(d) removing the mask.

2. The method of claim 1 wherein the amorphous carbon contains incorporated hydrogen.

3. The method of claim 1 wherein the mask is removed by dry processing.

4. A durable mask for use in the dry etch processing of Si by chlorine containing ambients, comprising:

a layer of amorphous carbon over the Si resistant to attack by chlorine and having openings which expose the Si so that it can be etched by chlorine.

FIG. 1a

FIG. 1b

FIG. 1c

FIG. 1d

FIG. Ie

14
13
12
11
10

FIG. If

13
12
11
10

FIG. Ig

12
11
10

FIG. Ih

12
11
10

FIG. 1i

12
11
10

FIG. 1j

11
10

FIG. 1k

10

European Patent Office

**EUROPEAN SEARCH REPORT**

Application Number

EP 92 42 0184

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | PATENT ABSTRACTS OF JAPAN vol. 11, no. 363 (E-560)26 November 1987 & JP-A-62 136 820 ( NIPPON TELEGR & TELEPH CORP ) 19 June 1987 * abstract * | 1,2,4 | H01L21/308 H01L21/314 |
| Y | US-A-5 022 959 (KENJI ITOH) * abstract * * column 3, line 40 - line 47 * & JP-A-2 058 221 (SEMICONDUCTOR ENERGY LAB) 27 February 1990 | 1,2,4 | |
| A | EP-A-0 175 980 (ENERGY CONVERSION DEVICES) | | |
| | | | TECHNICAL FIELDS SEARCHED (Int. Cl.5 ) |
| | | | H01L C23C |

The present search report has been drawn up for all claims

| Place of search | Date of completion of the search | Examiner |
|---|---|---|
| BERLIN | 15 SEPTEMBER 1992 | LE MINH I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)